# EUROPEAN PATENT APPLICATION

(11) **EP 4 338 952 A1**
(43) Date of publication of application: **20.03.2024**
(21) Application number: 23196991.6
(22) Date of filing: 12.09.2023
(51) Int. Cl.: B32B 17/10, G06F 1/16, H04M 1/02

(54) **PORTABLE ELECTRONIC DEVICES WITH TRANSPARENT LAYERS**

(30) Priority: 15.09.2022 US 202263407031 P; 02.06.2023 US 202318328077
(71) Applicant: Apple Inc., Cupertino CA 95014 (US)
(72) Inventor: WILSON, James R., Saratoga (US); ROGERS, Matthew S., San Jose (US); MARSHALL, Tyler A., Fremont (US); SINGAMSETTY, Divakar, San Jose (US)
(74) Representative: Froud, Christopher Andrew

(57) **Abstract**

Portable electronic devices (10) may be provided with components such as displays (22) and cameras (20) mounted in an interior region of a housing (12). A transparent layer (14) may be mounted to the housing (12) and may overlap the components. The transparent layer (14) may have glass layers (34) and polymer layers (40) attached to the glass layers (34).

## Description

This application claims priority to U.S. patent application No. 18/328,077, filed June 2, 2023, and U.S. provisional patent application No. 63/407,031, filed September 15, 2022.

### Field

This relates generally to systems with transparent layers, and, more particularly, to laminated transparent layers.

### Background

Glass can be used to form transparent layers such as windows and protective cover layers. Some transparent layers are formed by laminating multiple layers of glass together.

### Summary

Systems such as electronic device systems may be provided with components such as displays and cameras mounted in an interior region of a housing. A transparent layer may be mounted to the housing. In an illustrative configuration, the transparent layer overlaps the components and serves as a protective cover layer.

The transparent layer may have inner and outer glass layers. Polymer layers may be attached to inner and outer glass layers to enhance durability. The polymer layers may include an inwardly facing polymer film attached to the inner surface of the inner glass layer with adhesive and an outer polymer layer located between the inner and outer glass layers. The outer glass layer may be thinner than the inner glass layer.

### Brief Description of the Drawings

FIG. 1 is a perspective view of an illustrative system with a transparent layer in accordance with an embodiment.
FIG. 2 is a cross-sectional side view of an illustrative transparent layer overlapping optical components that operate through the transparent layer
FIG. 3 is a cross-sectional side view of an illustrative transparent layer in accordance with an embodiment.

### Detailed Description

Transparent layers may be used to form windows in buildings, vehicles, and/or other systems. Transparent layers may also be used in forming protective cover layers such as cover layers for optical components.

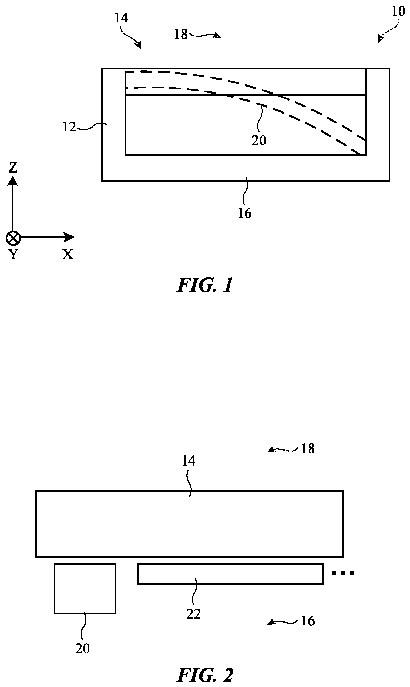

FIG. 1 is a cross-sectional side view of an illustrative system containing a transparent layer. System 10 of FIG. 1 has a support such as support 12 in which one or more transparent layers such as transparent layer 14 may be mounted. System 10 may be a building (e.g., support 12 may include building walls), may be a vehicle (e.g., support 12 may be vehicle body), may be an electronic device (e.g., support 12 may be an electronic device housing such as a head-mounted housing for a head-mounted device), and/or may be any other suitable system. In arrangement in which system 10 is a building or vehicle, layer 14 may serve as a window. In arrangements in which system 10 is an electronic device, layer 14 may overlap and protect components in the device. For example, layer 14 may serve as a protective cover layer that overlaps optical components. In an illustrative configuration, system 10 is a portable electronic device (e.g., a cellular telephone, head-mounted device, tablet computer, laptop computer, wristwatch, etc.).

Transparent layer 14 and support 12 may separate interior region 16 of system 10 from exterior region 18. System components may be mounted in interior region 16. Layer 14 may have opposing inner and outer surfaces. The outer surface of layer 14 may face exterior region 18 and the inner surface of layer 14 may face interior region 16. The surfaces of layer 14 may include planar portions and/or portions that are curved. For example, layer 14 may have a shape with a curved cross-sectional profile such as shape 20. In arrangements in which layer 14 is curved, the inner and outer surfaces may be parallel to each other (e.g., the thickness of layer 14 may be constant across layer 14). If desired, some or all of the surfaces of layer 14 may have compound curvature (surfaces that can only be flattened into a plane with distortion). Surface areas of compound curvature may be bent about both the X and Y axes of FIG. 1.

FIG. 2 shows how layer 14 may overlap components in interior region 16 such as illustrative components 20 and 22. Components 20 and 22 may include optical components that emit and/or detect light. As an example, component 22 may be a display that emits visible light that passes though layer 14. This allows a viewer in exterior region 18 to view an image on the display through layer 14 (e.g., layer 14 may serve as a display cover layer). Components such as component 20 may include, for example, visible and/or infrared cameras and/or other optical sensors that receive light through layer 14. By overlapping components 20 and 22 as shown in FIG. 2, layer 14 may serve as a protective cover layer for components 20 and 22.

During events such as drop events in which system 10 abruptly contacts the ground or other hard surface, layer 14 may be subjected to undesirably large amounts of stress. To help enhance durability, layer 14 may be provided with one or more layers of polymer. As an example, a polymer layer may be used to laminate multiple layers of transparent material together and/or polymer layers may be formed on exposed inner and/or outer surfaces of layer 14.

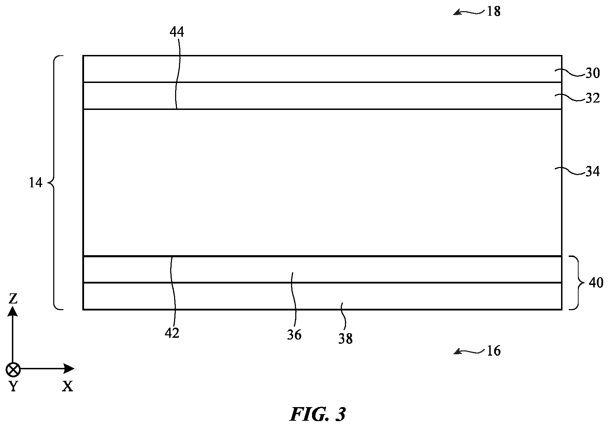

FIG. 3 is a cross-sectional side view of layer 14. As shown in FIG. 3, layer 14 may include multiple layers of transparent material such as layers 40, 34, 32, and 30. In an illustrative configuration, layer 14 includes two layers of hard transparent material and one or more softer layers that are attached to the harder layers. The softer layers may be, for example, polymer layers that help enhance durability.

In the example of FIG. 3, layer 34 may be a hard layer such as a layer of glass (including glass ceramic) or sapphire or other crystalline material. Illustrative configurations in which layer 34 is a layer of glass may sometimes be described herein as an example. Layer 34 may be formed from alumina silicate glass or other glass materials and may optionally be chemically strengthened using an ion-exchange chemical strengthening process that places the surfaces of layer 34 in compression relative to the core of layer 34. Layer 34 may have a thickness that is sufficient to provide layer 14 with some or all of its structural strength, so layer 34 may sometimes be referred to as a structural layer, structural transparent layer, or structural glass layer. Layer 34 may, as an example, have a thickness of 700 microns, at least 400 microns, at least 500 microns, at least 600 microns, less than 1200 microns, less than 1000 microns, less than 900 microns, less than 800 microns, 400-1200 microns, 400-1100 microns, 400-1000 microns, 400-800 microns, and/or other suitable thickness.

One or more polymer layers may be attached to layer 34. In an illustrative configuration, polymer layer 40 is attached to inner surface 42 of layer 34. Layer 40 may include a first layer such as layer 38 and a second layer such as layer 36. Layer 38 may be a polymer film (e.g., a film of polycarbonate, polyethylene terephthalate, or other polymer film) and may have a thickness of 50 microns, 10-250 microns, 25-100 microns, at least 20 microns, less than 200 microns, less than 150 microns, or other suitable thickness. Layer 36 may be a polymer layer such as a layer of polymer adhesive (e.g., epoxy, acrylic adhesive, cured liquid adhesive, pressure sensitive adhesive, and/or other adhesive) that attaches layer 38 to layer 34 and may have a thickness of 100 microns, 20-500 microns, at least 30 microns, less than 250 microns, less than 300 microns, or other suitable thickness.

If desired, an additional polymer layer such as polymer layer 32 may be attached to upper surface outer surface 44 of layer 34. Layer 32 may be formed from an elastomeric polymer or other soft polymer material. Examples of materials that may be used in forming polymer layer 32 include polyvinyl butyral and ethylene vinyl acetate. Other polymers may be used in forming layer 32, if desired. Layer 32 may be the outermost layer of material of layer 14 (e.g., the outer surface of layer 32 may be exposed to region 18) or layer 32 may be covered with a harder outer layer.

As shown in FIG. 3, for example, layer 32, which may sometimes be referred to as an elastomeric polymer layer or polymer interlayer, may be used to attach a thin hard layer such as outer layer 30 to layer 34. The thickness of layer 32 may be 50 microns, 25-100 microns, at least 20 microns, at least 40 microns, at least 50 microns, less than 400 microns, 25-400 microns, less than 300 microns, less than 200 microns, 20-200 microns, 50-400 microns, or other suitable thickness. Layer 30 be formed from glass (including glass ceramic), a crystalline material such as sapphire, or hard polymer (e.g., hardened acrylic). The thickness of layer 30 is preferably less than the thickness of layer 34 to help minimize the weight of layer 14.

In an illustrative arrangement, layer 30 is formed as a separate layer (e.g., a separate glass layer from layer 34) that is attached to layer 34 by laminating layers 30 and 34 together using polymer layer 32. The thickness of layer 30 in this type of arrangement may be at least 50 microns, at least 75 microns, at least 100 microns, less than 300 microns, less than 250 microns, less than 200 microns, less than 150 microns, less than 100 microns, 50-200 microns, 25-300 microns, 50-150 microns, or other suitable thickness (e.g., a thickness that provides the outermost surface of layer 14 with sufficient hardness to resist scratches). In addition to resisting scratches, the inclusion of a hard outer layer such as layer 30 to layer 14 may help enhance the strength of layer 14 and thereby allow the thickness of layer 34 to be reduced. To help match the curvature of layers 30 and 34 in this type of arrangement, layers 30 and 34 may be formed into desired shapes using molding operations (e.g., glass molding), machining and/or polishing operations, etching (wet and/or dry chemical etching), and/or other suitable shaping operations.

In some embodiments, layer 30 may be deposited as a coating on layer 32. As an example, deposition techniques such as physical vapor deposition and sol-gel deposition may be used to deposit an inorganic dielectric layer of a hard material (e.g., a glass coating formed of silicon nitride, silicon oxynitride, zirconia, alumina, and/or other hard dielectric coating deposited by physical vapor deposition or a glass coating formed of an inorganic dielectric based on silicon oxide deposited by sol-gel deposition techniques). The thickness of this coating may be sufficient to allow the coating to enhance durability (e.g., to help prevent scratches in layer 32). As an example, layer 30 may have a thickness of at least 20 microns, at least 25 microns, at least 35 microns, and/or other suitable thickness). If desired, a liquid polymer (e.g., liquid acrylic) may be deposited and cured to form an acrylic-based hard coat (e.g., layer 30 may be a polymer hard coat that is harder than layer 32 and that therefore helps resist scratching).

To help protect the privacy of users, any personal user information that is gathered by sensors may be handled using best practices. These best practices including meeting or exceeding any privacy regulations that are applicable. Opt-in and opt-out options and/or other options may be provided that allow users to control usage of their personal data.

In accordance with an aspect of the invention, a portable electronic device is provided that includes a portable electronic device housing having an interior region, a camera in the housing and a transparent layer mounted to the housing that overlaps the camera, the transparent layer includes a first glass layer having a first thickness, a second glass layer having a second thickness that is less than the first thickness, the second thickness is less than 300 microns and a polymer layer between the first glass layer and the second glass layer, the first glass layer is between the polymer layer and the interior region and the first and second glass layers have compound surface curvature.

Preferably, second thickness is less than 250 microns.

Preferably, the portable electronic device includes a polymer film that is attached to the first glass layer with adhesive.

Preferably, the first thickness is between 400 microns and 1100 microns.

Preferably, the first glass layer includes aluminosilicate glass.

Preferably, the second glass layer is laminated to the first glass layer with the polymer layer.

Preferably, the second glass layer includes a deposited inorganic dielectric coating and the second thickness is at least 25 microns.

Preferably, the second thickness is at least 25 microns.

Preferably, the polymer layer has a thickness of 50 microns to 400 microns.

Preferably, the first thickness is between 400 microns and 1000 microns.

Preferably, the portable electronic device housing includes a head-mounted device housing and the second thickness is less than 300 microns.

Preferably, the portable electronic device includes a display that is configured to display images through the transparent layer.

In accordance with an aspect of the invention, an electronic device is provided that includes a portable electronic device housing, a display in the housing and a transparent layer mounted to the housing that overlaps the display, the display is configured to display an image through the transparent layer and the transparent layer includes a first glass layer having a first thickness and having compound surface curvature, a second glass layer having a second thickness that is less than the first thickness and having compound surface curvature and a polymer layer between the first glass layer and the second glass layer.

Preferably, the portable electronic device housing has an interior region and the first glass layer is between the polymer layer and the interior region.

Preferably, the second thickness is less than 300 microns.

Preferably, the first thickness is 400-1000 microns and the portable electronic device housing includes a head-mounted device housing.

Preferably, the polymer layer has a thickness of less than 200 microns.

In accordance with an aspect of the invention, a head-mounted device is provided that includes a head-mounted housing that separates an interior region from an exterior region, a display, a camera and a cover layer that is coupled to the head-mounted housing and that overlaps the camera and the display, the cover layer includes a glass layer having an inner surface facing the interior region and an exterior surface facing the exterior region, a first polymer layer attached to the inner surface and a second polymer layer attached to the outer surface.

Preferably, the glass layer has a thickness of 400 to 1000 microns, the cover layer further includes an additional glass layer with a thickness of less than 300 microns, the second polymer layer contacts the glass layer and contacts the additional glass layer and the glass layer is between the second polymer layer and the interior region.

Preferably, the cover layer has compound surface curvature.

The foregoing is merely illustrative and various modifications can be made to the described embodiments. The foregoing embodiments may be implemented individually or in any combination.

## Claims

1. A portable electronic device, comprising:
a portable electronic device housing having an interior region;
a camera in the housing; and
a transparent layer mounted to the housing that overlaps the camera, wherein the transparent layer comprises:
a first glass layer having a first thickness;
a second glass layer having a second thickness that is less than the first thickness, wherein the second thickness is less than 300 microns; and
a polymer layer between the first glass layer and the second glass layer, wherein the first glass layer is between the polymer layer and the interior region and wherein the first and second glass layers have compound surface curvature.

2. The portable electronic device defined in claim 1 further comprising a polymer film that is attached to the first glass layer with adhesive.

3. The portable electronic device defined in claim 1 or claim 2 wherein the first thickness is between 400 microns and 1000 microns.

4. The portable electronic device defined in claim 1 or claim 2 wherein the first thickness is between 400 microns and 1100 microns.

5. The portable electronic device defined in any preceding claim wherein the first glass layer comprises aluminosilicate glass.

6. The portable electronic device defined in any preceding claim wherein the second glass layer is laminated to the first glass layer with the polymer layer.

7. The portable electronic device defined in any preceding claim wherein the second glass layer comprises a deposited inorganic dielectric coating and wherein the second thickness is at least 25 microns.

8. The portable electronic device defined in any of claims 1 to 6 wherein the second thickness is at least 25 microns.

9. The portable electronic device defined in any preceding claim wherein the second thickness is less than 250 microns.

10. The portable electronic device defined in any of claims 1 to 8 wherein the portable electronic device housing comprises a head-mounted device housing and wherein the second thickness is less than 300 microns.

11. The portable electronic device defined in any preceding claim further comprising a display that is configured to display images through the transparent layer.

12. The portable electronic device defined in any preceding claim wherein the polymer layer has a thickness of 50 microns to 400 microns.

13. The portable electronic device defined in any of claims 1 to 11 wherein the polymer layer has a thickness of less than 200 microns.

14. The portable electronic device defined in any preceding claim wherein the portable electronic device housing separates the interior region from an exterior region, wherein the first glass layer has an inner surface facing the interior region and an exterior surface facing the exterior region, the transparent layer further comprising:
an additional polymer layer attached to the inner surface.
